**Europäisches Patentamt**

**European Patent Office**

**Office européen des brevets**

(11) Veröffentlichungsnummer: **0 046 551**
**A2**

(12) # EUROPÄISCHE PATENTANMELDUNG

(21) Anmeldenummer: **81106344.5**

(22) Anmeldetag: **14.08.81**

(51) Int. Cl.³: **G 11 C 11/40**

(30) Priorität: **27.08.80 DE 3032333**

(43) Veröffentlichungstag der Anmeldung:
**03.03.82 Patentblatt 82/9**

(84) Benannte Vertragsstaaten:
**BE FR GB IT NL**

(71) Anmelder: **SIEMENS AKTIENGESELLSCHAFT Berlin und München**
**Postfach 22 02 61**
**D-8000 München 22(DE)**

(72) Erfinder: **Oldham, William G., Professor**
**762, Colusa Avenue**
**El Cerreto California 94530(US)**

(54) **Monolithische statische Speicherzelle und Verfahren zu ihrem Betrieb.**

(57) Monolithische statische Speicherzelle mit zwei kreuzge-koppelten Invertern (Flipflop), deren Lastelemente als Feldef-fekttransistoren (T2,T4) ausgebildet sind. Angestrebt wird eine erste Vorzugslage beim Anschalten der Versorgungs-spannung ($U_{cc}$), die in die entgegengesetzte Vorzugslage umgeschrieben werden kann. Dies wird dadurch erreicht, daß die genannten Feldeffekttransistoren (T2, T4) mit unter-schiedlichen Kanalwiderständen ausgebildet sind (1. Vor-zugslage) und daß die Gate-Isolierschicht eines (T4) dersel-ben unter dem Einfluß eines diese selektiv abtastenden Elektronenstrahls in ihrem Ladungszustand verändert wird (18). Die hierdurch verursachte Änderung seines Kanalwider-standes kehrt das Größenverhältnis der beiden Kanalwider-stände um. Der Anwendungsbereich umfaßt RAMs mit kundenspezifisch veränderbaren, fest eingespeicherten Prü-finformationen.

FIG 1

SIEMENS AKTIENGESELLSCHAFT          Unser Zeichen

Berlin und München                 VPA 80 P 8 0 4 1 E

Monolithische statische Speicherzelle und Verfahren zu ihrem Betrieb.

Die Erfindung bezieht sich auf eine monolithische statische Speicherzelle nach dem Oberbegriff des Patentanspruchs 1 und auf Verfahren zu ihrem Betrieb.

Eine solche Speicherzelle, die in digitalen Halbleiterspeichern mit wahlfreien Zugriff (RAM) verwendet wird, ist beispielsweise aus dem Buch "Daten-Speicher" von H. Kaufmann, R. Oldenbourg Verlag, München 1973, Seiten 146-150, nach Aufbau und Wirkungsweise bekannt.

Der Erfindung liegt die Aufgabe zugrunde, eine Speicherzelle dieser Art so auszubilden, daß sie einerseits beim Anschalten der Versorgungsspannung in eine vorbestimmte Lage kippt, so daß auf diese Weise eine erste digitale Information ständig gespeichert ist, und daß andererseits diese erste digitale Information bei Bedarf durch eine zweite digitale Information ersetzt werden kann. Diese Aufgabe wird erfindungsgemäß durch die im Patentanspruch 1 angegebenen Merkmale gelöst.

Der mit der Erfindung erzielbare Vorteil liegt insbesondere darin, daß das Umschreiben von der ersten in der Speicherzelle ständig gespeicherten digitalen Information auf die zweite digitale Information mit Hilfe eines mit einem herkömmlichen Elektronenstrahlschreiber erzeugten Elektronenstrahls erfolgt, ohne daß hierzu ein Maskierungsschritt notwendig wäre. Außerdem kann das Umschreiben vorgenommen werden, nachdem die Metallisierungen der monolithisch integrierten Schaltung aufgebracht sind, so daß das Herstellungsverfahren bis zu dem Verfahrensschritt, mit dem

St 1 Dxl / 22.08.1980

die leitenden Belegungen aufgebracht und definiert werden, von den Umschreibevorgängen nicht beeinflußt wird.

Die Ansprüche 2 bis 4 sind auf bevorzugte Ausgestaltungen und Weiterbildungen der Speicherzelle nach der Erfindung gerichtet, während die Ansprüche 5 bis 7 bevorzugte Verfahren zum Betrieb einer solchen Speicherzelle angeben.

Die Erfindung wird nachfolgend an Hand der Zeichnung näher erläutert. Dabei zeigt:

Fig. 1 ein Schaltbild einer ersten erfindungsgemäß ausgebildeten Speicherzelle,

Fig. 2 den Querschnitt einer Teilschaltung von Fig. 1

Fig. 3 eine erste alternative Ausbildung der Teilschaltung von Fig. 2 im Querschnitt,

Fig. 4 eine zweite alternative Ausbildung der Teilschaltung von Fig. 2 im Querschnitt und

Fig. 5 ein Schaltbild einer zweiten erfindungsgemäß ausgebildeten Speicherzelle.

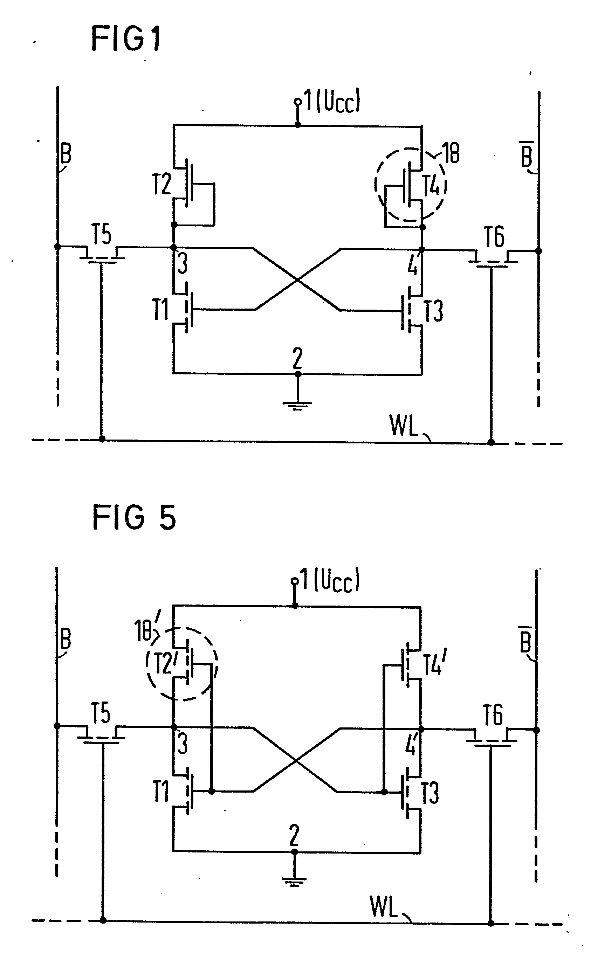

In Figur 1 wird von einer auf einem Halbleiterkörper monolithisch integrierten, statischen Speicherzelle ausgegangen, die aus zwei kreuzgekoppelten Invertern aufgebaut ist. Der erste Inverter weist einen Feldeffekt-Schalttransistor T1 und ein zu diesem in Serie geschaltetes Lastelement auf, das aus einem Feldeffekttransistor T2 besteht, dessen Gateelektrode mit seinem Sourceanschluß verbunden ist. Der zweite Inverter ist in analoger Weise aus einem Feldeffekt-Schalttransistor T3 und einem Feldeffekttransistor T4 gebildet. T1 und T3 sind dabei Transistoren des Anreicherungstyps, während T2 und T4 Transistoren des Verarmungstyps sind. Die Drainanschlüsse von T2 und T4 sind über einen Anschluß 1 mit einer Versorgungsspannung $U_{cc}$ beschaltet, während die Sourceanschlüsse von T1 und T3 mit einem an der Bezugsspannung liegenden Anschluß 2 verbunden sind.

Der Knoten 3, der den Ausgang des Inverters T1,T2 darstellt, ist mit dem Eingang des Inverters T3, T4 verbunden, während der Knoten 4, d.h. der Ausgang des Inverters T3, T4, an den Eingang des Inverters T1,T2 geführt ist. Zur Ansteuerung der Speicherzelle dient eine Wortleitung WL, die mit den Gateelektroden zweier Auswahltransistoren T5 und T6 verbunden ist. Eine Bitleitung B ist über die Source-Drain-Strecke von T5 mit dem Knoten 3 verbunden, während eine zweite Bitleitung $\bar{B}$ über die Source-Drain-Strecke von T6 mit dem Knoten 4 in Verbindung steht.

Beim Einschreiben einer logischen "1" oder "0" wird jeweils die Bitleitung B oder $\bar{B}$ auf Bezugspotential gelegt, wodurch der Schaltungszweig mit den Transistoren T3,T4 oder der mit den Transistoren T1,T2 über den zugeordneten Feldeffekt-Schalttransistor gesperrt wird, während der jeweils andere Schaltungszweig wegen des leitenden Zustandes des in ihm enthaltenen Feldeffekt-Schalttransistors dabei stromdurchflossen ist. Im gesperrten Zustand des Schaltungszweiges mit T1,T2 liegt der Knoten 3 etwa an der Versorgungsspannung $U_{cc}$, während der Knoten 4 annähernd auf Bezugspotential liegt. Ist dagegen der Schaltungszweig T3,T4 gesperrt, so kehren sich die Spannungsverhältnisse an den Knoten 3 und 4 um. Beim Auslesen der gespeicherten Information werden dann die Bitleitungen B und $\bar{B}$ über die Source-Drain-Strecken von T5 und T6 auf die informationabhängigen Potentiale der Knoten 3 und 4 geschaltet, wobei je nach der auszulesenden Information die eine oder andere Bitleitung stromführend wird.

Um zu erreichen, daß die Speicherzelle beim Anschalten der Versorgungsspannung $U_{cc}$ in eine vorbestimmte Lage kippt, die einer ständig eingespeicherten digitalen Information entspricht, sind nun die Feldeffekttransistoren T2 und T4 mit unterschiedlichen Kanalwiderständen ausgebildet. Zu diesem Zweck werden insbesondere die Abmessungen ihrer Source-Drain-Kanäle unterschiedlich ausgeführt. Weist der Transistor T3 beispielsweise eine Kanalbreite W auf, die zu seiner Kanallänge L in einem Verhältnis 20 : 4 steht, während der Quotient aus Kanalbreite zu Kanallänge beim Transistor T4 z.B. 15 : 4 beträgt, so ist der Kanalwiderstand von T3 wegen der größeren Kanalbreite niedriger als der von T4. Hierbei wird die Speicherzelle beim Anschalten von $U_{cc}$ stets in die Lage kippen, in der der Knoten 3 etwa auf dem Potential des Anschlusses 1 und der Knoten 4 etwa auf dem Potential des Anschlusses 2 liegen. Die in dieser Weise gespeicherte Information kann für Test- oder Prüfzwecke verwendet werden.

Unabhängig von der beim Anschalten der Versorgungsspannung $U_{cc}$ vorhandenen Information wird dann der Speicherzelle im Betrieb jede beliebige digitale Information in der oben beschriebenen Weise elektrisch eingeschrieben und aus ihr wieder ausgelesen.

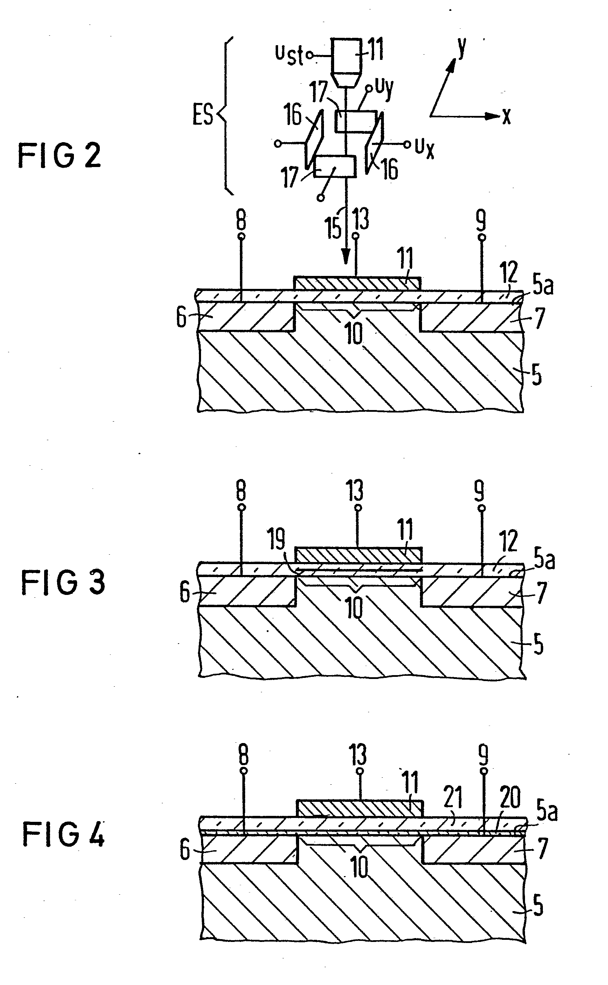

Der Feldeffekttransistor T4 ist in Figur 2 im Schnitt dargestellt. Er ist in einen z.B. aus Silizium bestehenden Halbleiterkörper 5 integriert und bei einer p-Dotierung desselben als eine N-Kanal-MIS-Struktur des Anreicherungstyps ausgebildet, wobei unter einer MIS-Struktur ganz allgemein eine Struktur verstanden wird, die einen Halbleiterkörper und einen durch eine elektrisch isolierende Schicht von diesem getrennte metallische Schicht umfaßt. T4 weist in Figur 2 mit 6 und 7 bezeichnete, in den Halbleiterkörper 5 eingefügte, $n^+$-dotierte Source- und Draingebiete auf, die sich bis zur Grenzfläche 5a des Halbleiterkörpers 5 erstrecken und mit Anschlüssen 8 und 9 versehen sind. Zwischen den Gebieten 6 und 7 befindet sich an der Grenzfläche 5a der Kanalbereich 10, der von einer metallisch leitenden Gateelektrode 11 überdeckt ist, die durch eine Gate-Isolierschicht 12, z.B. aus $SiO_2$, von der Grenzfläche 5a getrennt ist. Die Gateelektrode 11 besitzt einen Anschluß 13.

In Figur 2 ist weiterhin ein Elektronenstrahlschreiber ES angedeutet, der mit einer Elektronenkanone 14 versehen ist. Ein von dieser ausgehender Elektronenstrahl 15 wird durch zwei Ablenksysteme mit den Plattenpaaren 16 und 17, die jeweils mit Spannungen $u_x$ und $u_y$ beschaltet sind, in den Richtungen x und y abgelenkt. Der scharf fokussierte Elektronenstrahl 15 überstreicht nun in Abhängigkeit von den Spannungen $u_x$ und $u_y$ die Oberfläche des Halbleiterkörpers 5 beispielsweise in einzelnen parallel zueinander verlaufenden Zeilen. Ein derartiger Elektronenstrahlschreiber, der lediglich an Stelle von elektrostatischen Ablenksystemen 16 und 17 mit magnetischen Ablenksystemen ausgestattet ist, kann der Zeitschrift Philips techn. Rundschau 35, 1975/76, Nr. 3, Seiten 72-84, insbesondere Seite 73, Bild 1, entnommen werden.

Der Elektronenstrahl 15 wird durch eine zugeführte Steuerspannung $u_{st}$ jeweils nur dann eingeschaltet, wenn er gerade den Kanalbereich 10 überstreicht. Bei einer Stromdichte des Elektronenstrahls 15 von z.B. $1A/cm^2$, einer Beschleunigungsspannung von etwa 25 keV und einer lokalen Einwirkungsdauer von etwa $10^{-6}$s bilden sich in der Gate-Isolierschicht 12 Ladungsträgerpaare, von denen jeweils die negativen Ladungsträger in den mit einem Bezugspotential beschalteten Halbleiterkörper 5 abfließen, während die positiven Ladungsträger in der Gate-Isolierschicht 12 verbleiben und diese positiv aufladen. Eine Aufladung annähernd gleicher Größe ergibt sich aber auch für eine Stromdichte von 100 $A/cm^2$ und einer Einwirkungsdauer von $10^{-8}$s bei gleichbleibender Beschleunigungsspannung. Hieraus ist ersichtlich, daß die Größe der positiven Aufladung im wesentlichen von dem Produkt aus Stromdichte und Einwirkungsdauer abhängt. Die genannten Zahlenwerte sind jedoch nur beispielsweise Angaben und können im Rahmen der Erfindung je nach der Größe der gewünschten positiven Aufladung variiert werden.

Durch die positive Aufladung der Gate-Isolierschicht 12 verschiebt sich die Einsatzspannung $U_t$ des N-Kanal-Transistors T4 auf einen niedrigeren Wert. Das bedeutet aber, daß der Kanalwiderstand von T4 verringert wird. Geschieht dies in einem solchen Ausmaß, daß der Kanalwiderstand von T4 kleiner wird als der Kanalwiderstand von T2, so wird beim Anschalten von $U_{cc}$ die Speicherzelle nicht mehr in die geometrisch bedingte Vorzugslage kippen, sondern in die entgegengesetzte.

Durch die Bestrahlung von T4 mit dem Elektronenstrahl 15 in der beschriebenen Weise, die in Figur 1 durch die gestrichelte Umrandung 18 angedeutet wird, gelingt es also, die auf Grund der geometrischen Abmessungen der Kanalbereiche von T2 und T4 ständig gespeicherte Information durch eine andere Information zu überschreiben, bei der nach dem Einschalten die jeweils andere Vorzugslage eingenommen wird. Diese Information kann beispielsweise eine dem Anwender individuell zugeordnete Test- oder Prüfinformation sein, die von dem vom Hersteller zunächst verwendeten, geometrisch implementierten Prüf- oder Testinformationen abweicht. Auf diese Weise können bei einer Mehrzahl von in Zeilen und Spalten angeordneten Speicherzellen sowohl vom Hersteller vorgegebene Test- oder Prüfdaten ständig eingespeichert werden als auch auf einfache Weise Veränderungen dieser Test- oder Prüfdaten auf Grund von Anwenderwünschen vorgenommen werden.

Eine selektive Verschiebung der Einsatzspannung von T4 kann auch in der Weise erfolgen, daß zunächst die Einsatzspannungen beider Feldeffekttransistoren T2 und T4 bzw. aller Feldeffekttransistoren T1 bis T4 durch eine gemeinsame Bestrahlung mit Röntgenstrahlen oder mit dem Elektronenstrahl eines Elektronenstrahlschreibers, dessen Stromdichte, Einwirkungsdauer und Beschleunigungsspannung in der beschriebenen Weise gewählt sind, jeweils auf einen niedrigeren Wert verschoben werden und daß danach eine

0046551

zusätzliche selektive Bestrahlung der Kanalbereiche der Transistoren T1 bis T3 bzw. des Transistors T2, deren Einsatzspannungen nicht verändert werden sollen, mit einem Elektronenstrahl 15 sehr großer Leistungsdichte erfolgt. Diese Leistungsdichte wird so gewählt, daß sich die Gate-Isolierschicht 12 der letzt genannten Transistoren jeweils auf eine Temperatur von etwa 500 bis 600°C erwärmt, wobei die gespeicherten positiven Ladungsträger in den Halbleiterkörper 5 abfließen, so daß die Gate-Isolierschicht wieder entladen und der ursprüngliche Wert der Einsatzspannung wieder erreicht wird. Hierbei kommen z.B. eine Stromdichte von 100 bis 500 $A/cm^2$ und eine lokale Einwirkungsdauer von $10^{-4}$s bei einer Beschleunigungsspannung von 25 keV in Betracht.

Vorteilhafte Weiterbildungen des Transistors T4 sind in den Figuren 3 und 4 dargestellt. In Figur 3 ist eine Polisiliziumschicht 19, die von äußeren Potentialen freigeschaltet ist und sich daher in einem Zustand des "floating" befindet, in die Gate-Isolierschicht 12 eingefügt. Nach Figur 4 besteht die Gate-Isolierschicht von T4 aus zwei verschiedenen Teilschichten, z.B. aus einer $SiO_2$-Schicht 20 und einer darüberliegenden $Si_3N_4$-Schicht 21. Bei diesen Ausführungen des Transistors T4 werden die Ladungszustände der Gate-Isolierschicht durch die leitende Schicht 19 oder durch die Grenzfläche zwischen den Teilschichten 20 und 21 stabilisiert. Zweckmäßigerweise ist auch der Transistor T2 nach den Figuren 2 oder 3 weitergebildet.

Eine andere Möglichkeit der Umschreibung der Speicherzellen T1 bis T4 aus einer geometrisch bedingten Vorzugslage beim Anschalten der Versorgungsspannung in die entgegengesetzte Vorzugslage besteht darin, daß die Einsatzspannung des N-Kanaltransistors T2, der einen kleineren Kanalwiderstand hat, durch eine negative Aufladung seiner Gate-Isolierschicht in Richtung auf größere Werte verschoben wird. Der Betrag dieser Verschiebung wird dabei so gewählt, daß der hieraus resultierende Kanalwiderstand von T2 größer wird als der Kanalwiderstand von T4. Zu diesem Zweck wird vorteilhafterweise ein gemäß den Figuren 3 oder 4 weitergebildeter Transistor T2 verwendet, dessen Polysiliziumschicht 19 oder dessen Grenzfläche zwischen den Teilschichten 20 und 21 in herkömmlicher Weise negativ aufgeladen wird. Eine solche negative Aufladung wird beispielsweise in "A Users Handbook of Semiconductor Memories" von E.R. Hnafek, Verlag John Wiley & Sons, New York, 1977, Seiten 242-245 und 248, 249 oder in den Siemens Forschungs- und Entwicklungsberichten, Band 4 (1975), Nr. 6, Seiten 345-351 beschrieben. In vielen Fällen wird es zweckmäßig sein, zunächst die Gate-Isolierschichten beider Transistoren T2 und T4 in dieser Weise negativ aufzuladen und anschließend eine selektive Bestrahlung des Kanalbereiches 10 des Transistors T4 mit dem Elektronenstrahl 15 vorzunehmen, dessen Stromdichte, Einwirkungsdauer und Beschleunigungsspannung in der bereits beschriebenen Weise gewählt sind, so daß sich die Gate-Isolierschicht von T4 auf eine Temperatur erwärmt, bei der sie sich entlädt. Dabei nimmt T4 wieder seine ursprüngliche Einsatzspannung an, während die Verschiebung der Einsatzspannung von T2 auf einem größeren Wert bestehen bleibt.

Figur 5 zeigt eine in Komplementärkanaltechnik ausgeführte Speicherzelle nach der Erfindung. Hierbei sind T1 und T3 als N-Kanal-Transistoren des Anreicherungstyps ausgebildet, während T2' und T4' P-Kanal-Transistoren des Anreicherungstyps sind. Die Gateelektroden von T1 und T2' sowie von T3 und T4' sind untereinander verbunden. Die übrigen Schaltungsteile entsprechen den gleich bezeichneten Schaltungsteilen von Figur 1. In Figur 5 wird für den Fall, daß T3' eine größere Kanalbreite besitzt als T4', beim Anschalten von $U_{cc}$ wieder eine Vorzugslage eingenommen, bei der der Knoten 3 etwa auf dem Potential des Anschlusses 1 und der Knoten 4 etwa auf dem Potential des Anschlusses 2 liegen. Bestrahlt man den Kanalbereich von T2' oder Teile davon mit einem Elektronenstrahl 15 zum Zwecke einer positiven Aufladung der Gate-Isolierschicht, was in Figur 5 durch den gestrichelten Kreis 18' angedeutet ist, so wird beim Einstellen eines Kanalwiderstandes von T2', der größer ist als der von T4', eine Umkehrung der Vorzugslage beim Anschalten von $U_{cc}$ erreicht. Eine das gleiche bewirkende negative Aufladung muß hierbei an dem Transistor T4' vorgenommen werden.

Die zuletzt genannten Aufladungsregeln kommen auch dann in Betracht, wenn alle Transistoren T1 bis T4 als P-Kanal-Transistoren ausgebildet und in einen n-dotierten Halbleiterkörper 5 integriert sind.

7 Patentansprüche
5 Figuren

0046551

## Patentansprüche

1. Monolithische statische Speicherzelle mit zwei kreuzgekoppelten Invertern, die jeweils aus einer an einer Versorgungsspannung liegenden Serienschaltung eines Feldeffekt-Schalttransistors und eines als Feldeffekttransistor ausgebildeten Lastelements bestehen, d a d u r c h g e k e n n z e i c h n e t , daß die die Lastelemente bildenden Feldeffettransistoren (T2,T4) Kanalwiderstände unterschiedlicher Größe aufweisen und daß die Gate-Isolierschicht des Feldeffekttransistors mit dem größeren (kleineren) Kanalwiderstand (T4) mittels eines seinen Kanalbereich wenigstens teilweise abtastenden Elektronenstrahls (15) in seinem Ladungszustand derart veränderbar ist, daß die hierdurch bedingte Einsatzspannungsänderung eine Absenkung (Anhebung) seines Kanalwiderstandes unter (über) den Wert des Kanalwiderstandes des anderen Feldeffekttransistors (T3) ergibt.

2. Monolithisch statische Speicherzelle nach Anspruch 1, d a d u r c h g e k e n n z e i c h n e t , daß die die Lastelemente bildenden Feldeffekttransistoren (T2,T4) unterschiedliche Quotienten aus Kanalbreite zu Kanallänge aufweisen.

3. Monolithisch statische Speicherzelle nach Anspruch 1 oder 2, d a d u r c h g e k e n n z e i c h n e t , daß in die Gate-Isolierschicht wenigstens eines der die Lastelemente bildenden Feldeffekttransistoren (T2,T4) eine leitende Schicht (19) oder Störstellen eingefügt sind, die die Ladungszustände derselben stabilisieren.

4. Monolithische statische Speicherzelle nach Anspruch 1 oder 2, d a d u r c h g e k e n n z e i c h n e t , daß wenigstens einer der die Lastelemente bildenden Feldeffekttransistoren (T2,T4) als NNOS-Transistor ausgebildet ist, dessen Gate-Isolierschicht aus einer $SiO_2$-Schicht (20)

und einer darüberliegenden $Si_3N_4$-Schicht (21) besteht.

5. Verfahren zum Betrieb einer monolithischen statischen Speicherzelle nach einem der Ansprüche 1 bis 4, d a - d u r c h   g e k e n n z e i c h n e t , daß der Elektronenstrahl (15) eines Elektronenstrahlschreibers (ES) derart abgelenkt wird, daß er selektiv den Kanalbereich (10) desjenigen Feldeffekttransistors (T4), dessen Einsatzspannung verändert werden soll, oder einen Teil davon überstreicht und daß die Stromdichte, Einwirkungsdauer und Beschleunigungsspannung des Elektronenstrahls (15) so gewählt sind, daß er in der Gate-Isolierschicht (12) dieses Feldeffekttransistors (T4) eine positive Ladung erzeugt, die den Wert der Einsatzspannung von einem ohne diese Aufladung bestehenden niedrigeren Wert auf einen höheren Wert verschiebt oder umgekehrt.

6. Verfahren zum Betrieb einer monolithischen statischen Speicherzelle nach einem der Ansprüche 1 bis 4, d a - d u r c h   g e k e n n z e i c h n e t , daß beide die Lastelemente bildenden Feldeffekttransistoren (T2,T4) durch eine Bestrahlung mit Röntgenstrahlen oder mit einem von einem Elektronenstrahlschreiber (ES) erzeugten Elektronenstrahl (15), dessen Stromdichte, Einwirkungsdauer und Beschleunigungsspannung so gwählt sind, daß die Gate-Isolierschichten (12) der Feldeffekttransistoren (T2,T4) positiv aufgeladen werden, eine gemeinsame Verschiebung ihrer Einsatzspannungen erfahren und daß danach eine selektive Bestrahlung des Kanalbereiches (10) eines dieser Feldeffekttransistoren (T2) mit einem Elektronenstrahl (15) erfolgt, dessen Stromdichte, Einwirkungsdauer und Beschleunigungsspannung so gewählt sind, daß/die Gate-Isolierschicht (12) dieses Feldeffekttransistors sich auf eine Temperatur erwärmt, bei der sie wieder entladen wird, so daß dessen Einsatzspannung wieder ihren ursprünglichen Wert annimt.

0046551

7. Verfahren zum Betrieb einer monolithischen statischen Speicherzelle nach einem der Ansprüche 1 bis 4, d a - d u r c h  g e k e n n z e i c h n e t , daß die Gate-Isolierschichten (12) beider die Lastelemente bildenden Feldeffekttransistoren (T2,T4) zunächst in an sich bekannter Weise negativ aufgeladen werden, so daß diese Feldeffekttransistoren (T2,T4) eine gemeinsame Verschiebung ihrer Einsatzspannungen erfahren, und daß danach eine selektive Bestrahlung des Kanalbereichs eines (T4) dieser Feldeffekttransistoren mit dem Elektronenstrahl (15) eines Elektronenstrahlschreibers (ES) erfolgt, dessen Stromdichte, Einwirkungsdauer und Beschleunigungsspannung so gewählt sind, daß sich die Gate-Isolierschicht (12) des Feldeffekttransistors (T4) auf eine Temperatur erwärmt, bei der sie wieder entladen wird, so daß der zuletzt genannte Feldeffekttransistor (T4) eine Einsatzspannung aufweist, die dem ursprünglichen Wert entspricht.

FIG 1

FIG 5

FIG 2

FIG 3

FIG 4